# EUROPEAN PATENT APPLICATION

(11) **EP 0 618 679 A1**
(43) Date of publication of application: **05.10.1994**
(21) Application number: 93830130.6
(22) Date of filing: 31.03.1993
(51) Int. Cl.: H03K 17/12

(54) **High reliable integrated circuit structure for MOS power devices**

(71) Applicant: SGS-THOMSON MICROELECTRONICS S.r.l., I-20041 Agrate Brianza (Milano) (IT)
(72) Inventor: Murari, Bruno, I-20052 Monza (Milano) (IT); Marchio, Fabio, I-20018 Sedriano (Milano) (IT)
(74) Representative: Checcacci, Giorgio

(57) **Abstract**

A high-reliability integrated circuit structure, for power devices implemented in MOS technology, being of a type which comprises a plurality of basic cells (5), each having at least one MOS transistor (2) provided with respective gate (G), source (S), and drain (D) terminals, has all the respective source terminals (S) of the plural cells (5) connected together, and all the respective drain terminals (D) likewise interconnected. On the other hand, the respective gate terminals (G) are provided structurally independent and independently addressable. This enables the structure to operate correctly even with one or more of the basic cells at failure.

## Description

### Field of Application

This invention relates to an integrated circuit incorporating power devices implemented in MOS technology.

In particular, the invention concerns a high-reliability circuit structure, for power devices implemented in MOS technology, being of a type which comprises a plurality of basic cells, each having at least one MOS transistor with its associated gate, source and drain terminals.

### State of Art

As is well known, power devices implemented in MOS or CMOS technology are obtained by conneccting in parallel a very large number of basic cells, each including at least one MOS transistor.

Failure or malfunctioning may be expected of such devices, for example, due to a short between the gate and source terminals of a transistor of any one cell.

On the occurrence of a faulty state of this kind, as may be brought about by no more than one cell, the whole device ceases to operate.

The seriousness of such a failure is quite obvious, especially where the power devices are incorporated to integrated circuits. In cases such as this, a malfunction in the power circuit may easily impair the functionality and effectiveness of the whole integrated circuit.

Additionally, it is found that with integrated circuits employing power devices of the MOS type, the aforesaid faults may escape troubleshooting procedures carried out using diagnostic circuitry.

The technical problem underlying this invention is to provide a novel circuit structure for MOS power devices, which has such structural and functional features as to overcome the aforementioned drawbacks affecting the state of the art and allow proper operation of the integrated circuit even on the occurrence of a faulty condition.

### Summary of the Invention

The solutive idea on which the invention stands is to provide a redundant circuit structure which would let the whole device operate correctly even in the event of a short occurring in a basic cell thereof, while also issuing a fault warning.

Based on this solutive idea, the technical problem is solved by a circuit structure as previously indicated and as defined in the characterizing portion of Claim 1.

The features and advantages of a circuit structure according to the invention will become apparent from the following detailed description of an embodiment thereof, given by way of example and not of limitation with reference to the accompanying drawings.

### Brief Description of the Drawings

In the drawings:
- Figure 1 shows in diagram form a power circuit structure according to the prior art;
- Figure 2 shows in diagram form the structure of Figure 1 on the occurrence of a faulty state;
- Figure 3 shows in diagram form the circuit structure of the present invention;
- Figure 4 in diagram form the structure of Figure 3 on the occurrence of a faulty state;
- Figure 5 shows in diagram form the structure of Figure 4 as associated with a respective drive circuit; and,
- Figure 6 shows in diagram form the structure of Figure 4 as associated with another type of drive circuit.

### Detailed Description

With reference to the drawing figures, schematically indicated at 1 is a CMOS structure embodying this invention and including power transistors 2. The structure 1 is incorporated to an integrated circuit which also includes a drive circuit 12.

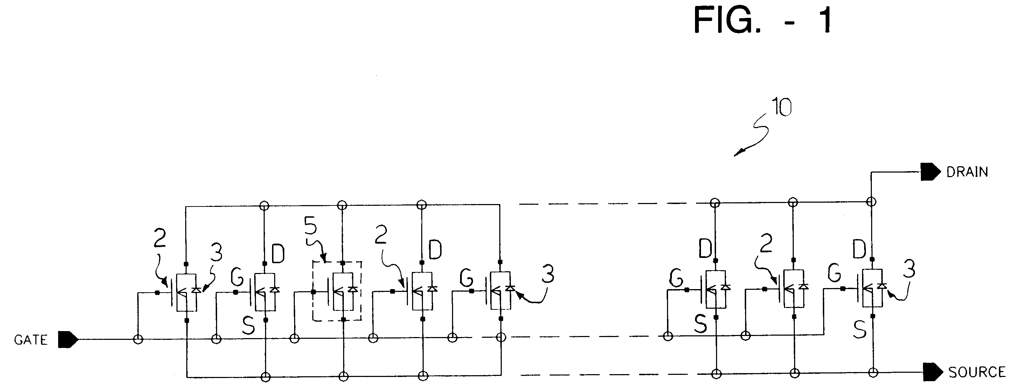

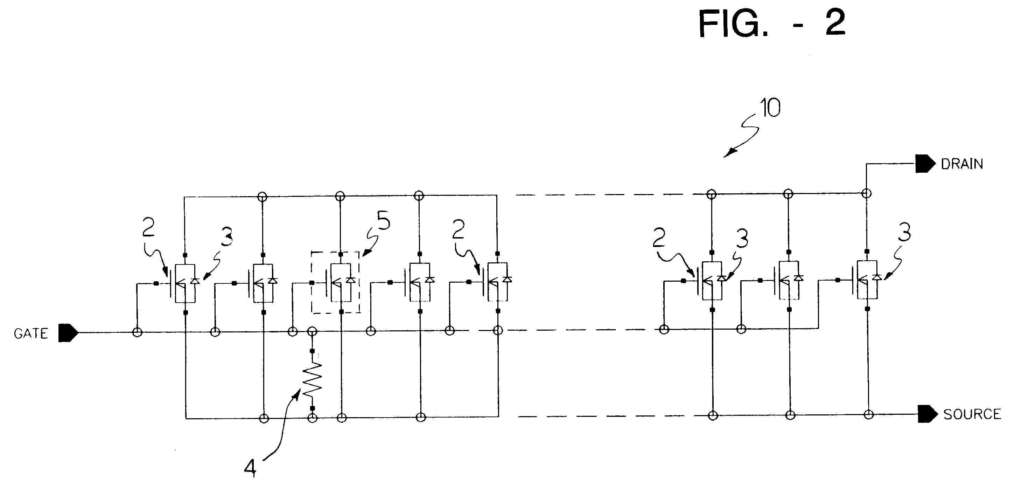

To make the invention more easily understood, it may be appropriate to give first a description of a conventional technical approach with reference to the examples illustrated by Figures 1 and 2.

Shown diagramatically in Figure 1 is a conventional circuit structure 10 which cmprises a plurality of basic cells 5, with each cell having at least one MOS power transistor 2. All the MOS transistors 2 of the cells 5 are connected in parallel with one another.

Each transistor 2 has respective gate G, source S, and drain D terminals. Also, a diode 3 is associated with each transistor 2, being connected between the drain D and source S terminals.

All the gate terminals G of the transistors 2 are connected together and led to a single point of contact designated "Gate".

Likewise, all the source terminals S are connected together and to a contact designated "Source", all the drain terminals D being led to a contact "Drain".

Illustrated diagramatically by Figure 2 is a failure situation originating, for example, from a fault in the gate oxide of a single cell 5. This fault may create a resistive path, equal to a few hundred Ohms in value, between the gate G and source S terminals of one transistor 2.

The presence of said fault has been represented schematically with a resistor 4 connected between the aforesaid terminals, G and S.

A drive circuit, not shown because known per se, is associated, as usual, with the structure 10, which drive circuit supplies a predetermined DC value to all the transistors. This current value disallows proper operation of the faulty transistor, i.e. the one having the resistor 4 associated with it.

This transistor would reach an undetermined state and prevent the whole structure 10 from operating correctly.

Let us see now how the invention addresses and solves this problem.

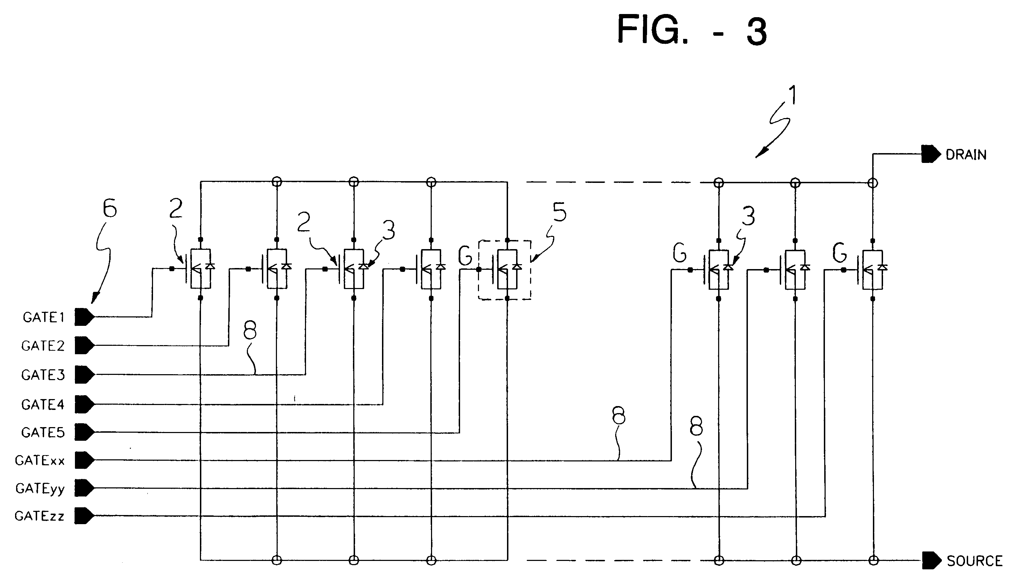

Figure 3 shows diagramatically the circuit structure 1 which embodies this invention. This structure 1 provides for the cells 5 to be only interconnected through the source S and drain D terminals of their respective transistors 2.

The gate terminals G of the individual transistors 2 are, on the contrary, kept structurally independent of one another.

Provided in the integrated circuit incorporating the structure 1, are two respective connection paths or "fingers" to which there are led, on the one side, all the source terminals S, and on the other side, all the drain terminals D.

Briefly, on the one side, all the source terminals S are placed in common, while on the other side, the same is done with the drain terminals D.

As relates to the gate terminals G, each of them is addressable in an independent manner. For this purpose, a set of addressing contacts Gate1, Gate2,..., GateN are provided, each connected to a corresponding gate terminal G by means of a connection "finger" 8 internal of the integrated circuit.

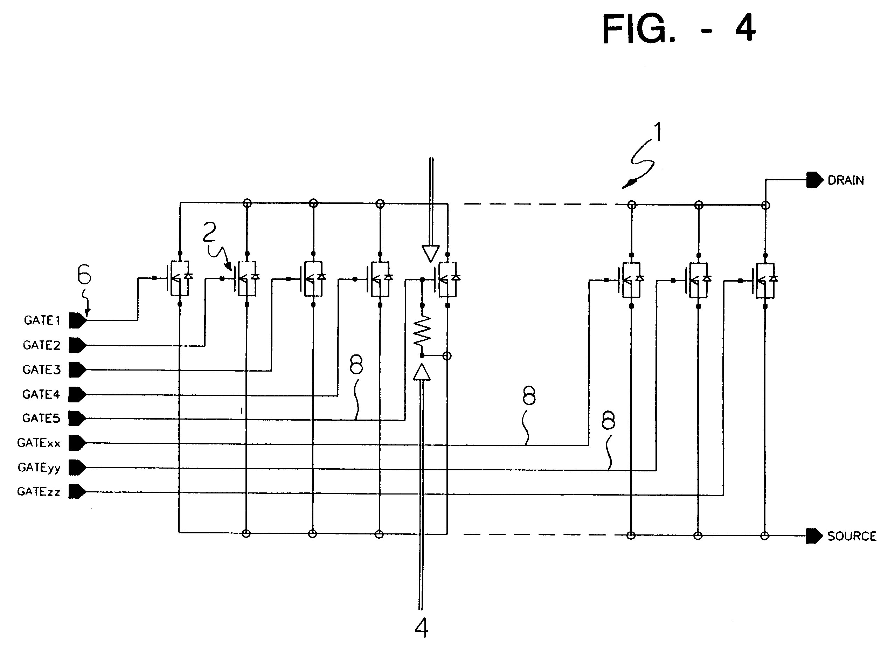

Figures 3 and 4 show the equivalent electric diagram of the power device according to the invention in its integrated circuit implementation form.

Specifically, Figure 4 illustrates schematically a faulty state of the structure 1, as exemplified by the presence of a resistor 4 between the gate G and source S terminals of a transistor 2. As previously mentioned, this resistor 4 is the equivalent of a failure in the gate oxide of its respective transistor.

Thus, in the event of a single cell being shorted, it is just the involved "finger" 8 that will cease to operate correctly, but this without affecting the operability of the whole structure.

Advantageously, the structure 1 of this invention is associated with a drive circuit 12.

A first embodiment of said circuit 12 comprises a plurality of parallel-connected resistors 7, each having one end connected to a corresponding contact in the set 6 of contacts. The opposite ends of all the resistors 7 are connected together and to an output of an inverter 11.

This inverter 11 has its input connected to a drive terminal 13.

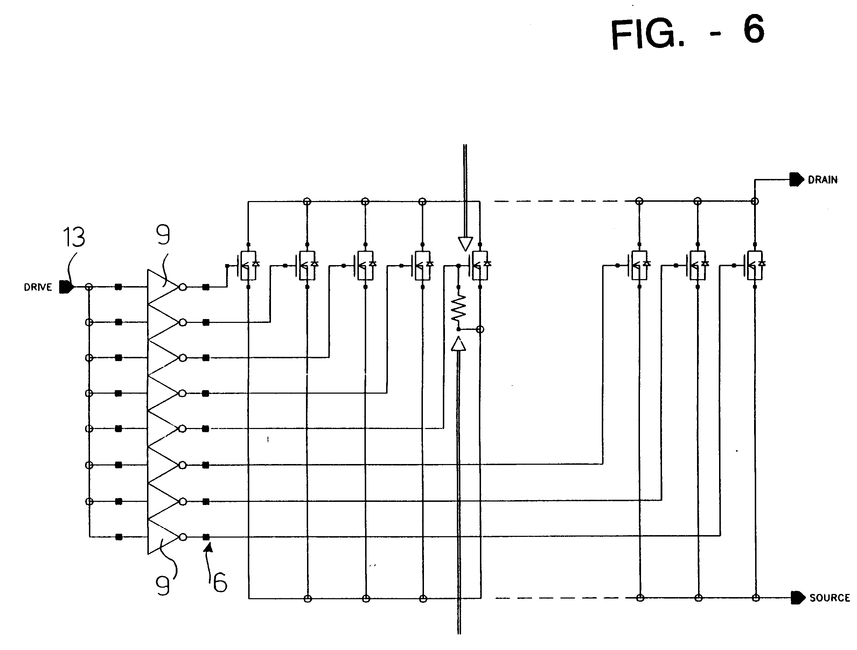

Figure 6 shows a second embodiment of the circuit 12. A plurality of inverters 9 connected in parallel have respective outputs, each connected to a corresponding contact in the contact set 6. The inputs of all the inverters 9 are led to the drive terminal 13.

The structure of this invention would also reveal any partial failure of the power device. In fact, a faulty condition can be detected using an appropriate measuring system as explained herein below.

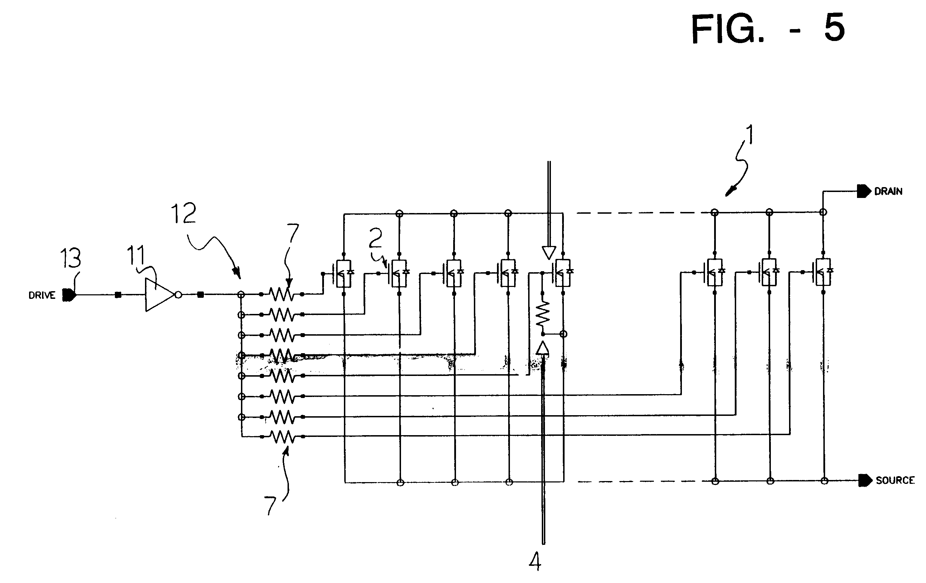

The current which enters a gate terminal would be null under static conditions, in which case the voltage across the resistors 7 in Figure 5 must be zero.

The possible appearance of a faulty condition in a connection "finger" between the drive circuit 12 and a gate terminal of a transistor 2 would result in a current draw other than zero. And this on account of the resistor 4 arranged to schematize the fault in the gate oxide.

The attendant voltage drop across that resistor 4 brings out the presence of the faulty state.

In the example of Figure 6, the output impedance of the inverters 11 is assumed to be sufficiently large to allow a voltage measurement to be taken at the gate terminal of each transistor. Also in this case, therefore, can any faulty state be detected based on a measurement of the voltage drop in the vicinity of the gate terminal.

Thus, the structure of this invention does solve the technical problem, and affords a number of advantages, first and foremost its ability to operate correctly even with one or more faulty basic cells.

Furthermore, and as previously expressed, this structure can provide a warning of a state of partial failure.

Understandably, changes and modifications may be made unto the circuit structure herein described and illustrated within the scope of the invention as defined in the appended claims.

## Claims

1. A high-reliability integrated circuit structure, for power devices implemented in MOS technology, being of a type which comprises a plurality of basic cells (5), each having at least one MOS transistor (2) with its associated gate (G), source (S), and drain (D) terminals, characterized in that the respective source terminals (S) of all said plural cells (5) are connected together, as are all of the respective drain terminals (D), whereas the respective gate terminals (G) are structurally independent of one another.

2. A circuit structure according to Claim 1, characterized in that said source terminals (S) are shared within the integrated circuit.

3. A circuit structure according to Claim 1, characterized in that said drain terminals (D) are shared in the integrated circuit.

4. A circuit structure according to Claim 1, characterized in that each gate terminal (G) is addressable in an independent manner.

5. A circuit structure according to Claim 4, characterized in that it includes a set (6) of addressing contacts (Gate1,Gate2,...,GateN), each connected to a corresponding gate terminal (G) through a connection (8) internal of the integrated circuit.

6. A circuit structure according to Claim 1, characterized in that it has a drive circuit (12) connected thereto.

7. A circuit structure according to Claim 6, characterized in that said drive circuit (12) comprises a plurality of parallel-connected resistors (7), each having one end connected to a corresponding contact in the contact set (6), and the other end, in common with those of the remaining resistors (7), connected to an output of an inverter (11).

8. A circuit structure according to Claim 6, characterized in that said drive circuit (12) comprises a plurality of parallel-connected inverters (9) having respective outputs connected each to a corresponding one in said contact set (6), the inputs of all the inverters (9) being led to one and the same drive terminal (13).
